# EUROPEAN PATENT APPLICATION

(11) **EP 4 309 945 A1**
(43) Date of publication of application: **24.01.2024**
(21) Application number: 22185368.2
(22) Date of filing: 18.07.2022
(51) Int. Cl.: B60L 3/00

(54) **VOLTAGE MEASURING DEVICE AND METHOD**

(71) Applicant: VOLVO TRUCK CORPORATION, 405 08 Göteborg (SE)
(72) Inventor: BRIKELL, Niklas, 423 72 GÖTEBORG (SE); LEANDERSSON, Kenny, 416 73 GÖTEBORG (SE); ÖJERGREN, Johan, 442 37 KUNGÄLV (SE)
(74) Representative: Kransell & Wennborg KB

(57) **Abstract**

A measuring device (30) and method 100 are provided for enabling measuring of traction voltage being supplied by a traction voltage system (10) to a high voltage appliance (22) in a vehicle with the traction voltage system in operation, the measuring device (30) being configured to be detachably connected between the vehicle traction voltage system (10) and the high voltage appliance (22), the measuring device (30) comprising a first and second terminal (32a, 32b) configured to receive a first and second probe of a voltage measuring instrument a first and second resistor (34a, 34b) arranged to connect each terminal (32a, 32b), upon the measuring device (30) being attached to the vehicle voltage traction system (10), to a first and second traction voltage conductor (12a-d) of the traction voltage system (10) extending through the measuring device (30) wherein the measuring device (30) is configured to, upon the measuring device (30) being attached to the vehicle voltage traction system (10), connect to a Hazardous Voltage Interlock Loop (HVIL) 18 of the vehicle extending through the measuring device (30) so that the HVIL (18) is broken when the measuring device (30) is detached from the traction voltage system (10), thereby inactivating the traction voltage system (10).

## Description

### TECHNICAL FIELD

The present disclosure relates to the field of voltage measuring and in particular to a measuring device and method for measuring of traction voltage in a vehicle with the traction voltage system in operation.

### BACKGROUND

Voltages in hybrid and all-electric vehicles are significantly higher than those in for example vehicles driven solely by an internal combustion engine. Upon servicing these kinds of vehicles, safety measures are thus often provided to protect a technician from being harmed during the measuring.

One safety system that is used in hybrid and all-electric vehicles today is the Hazardous Voltage Interlock Loop (HVIL). The HVIL comprises a low voltage loop which monitors the high voltage system and takes measures if hazard is detected. For example, the HVIL can shut down the entire high voltage system or a part of the high voltage system if unauthorized access to the system is discovered, or if a component is unintentionally disconnected.

Furthermore, measurement of traction voltage in an operating vehicle is generally performed using devices and software integrated in the vehicle, and not directly by a technician. Measuring devices exist which can be used by a technician for controlling if any voltage is prevailing in the traction voltage system prior to service, but those devices are used with the traction voltage system turned off and not while the traction voltage system is operating.

A problem with a permanently mounted measuring device is that there is no way of controlling the device before use. A further problem is that there exists no device for allowing measuring of traction voltage in an operating vehicle in a simple and safe way, without the use of vehicle integrated software or devices. Thus, if the software is malfunctioning, or if the vehicle does not comprise this kind of software, the traction voltage cannot be measured while the vehicle motor is operating.

### SUMMARY

It is an object of the present disclosure to resolve or at least mitigate the above-described deficiencies.

An objective of the present disclosure is to make available a device for enabling safe measuring of traction voltage in an operating vehicle.

An objective of the present disclosure is to make available a device for enabling safe measuring of traction voltage in an operating vehicle by a technician.

As the traction voltage is part of the high voltage circuit of the vehicle, it is beneficial if the measuring device comprises safety means for protecting the technician during measuring.

The term "operating" is used to describe that the motor of the vehicle is running, and thus that the traction voltage system is turned on.

To overcome the problems of the prior art, the present disclosure relates in a first aspect to a measuring device for enabling measuring of traction voltage being supplied by a traction voltage system to a high voltage appliance in a vehicle with the traction voltage system in operation,
the measuring device being configured to be detachably connected between the vehicle traction voltage system and the high voltage appliance, the measuring device comprising:
a first and second terminal configured to receive a first and second probe of a voltage measuring instrument,
a first and second resistor arranged to connect each terminal, upon the measuring device being attached to the vehicle voltage traction system, to a first and second traction voltage conductor of the traction voltage system extending through the measuring device,
wherein the measuring device is configured to, upon the measuring device being attached to the vehicle voltage traction system, connect to a Hazardous Voltage Interlock Loop (HVIL) of the vehicle extending through the measuring device so that the HVIL is broken when the measuring device is detached from the traction voltage system, thereby inactivating the traction voltage system. By providing a device that is detachable from the vehicle, unauthorized attempts to measure the traction voltage can be prohibited, as the device is not permanently mounted in the vehicle but only attached when service is to be performed.

By providing resistors between the conductors of the traction voltage system and the measuring probes, the user is protected from being exposed to harmful current in the traction voltage system. This allows for measurement to be conducted while the vehicle is operating, without the risk of harming the technician.

The inclusion of the resistors in the detachable measuring device, as opposed to having the resistors permanently installed in the vehicle, further makes it possible to test the resistors before attaching the measuring device to the vehicle, thus avoiding the risk of faulty measurement results or hazard due to a faulty resistor.

By connecting the measuring device to the existing HVIL of the vehicle, an additional safety measure is provided, as it prevents the high voltage system of the vehicle from being activated as long as the measuring device is not fully or correctly attached. Since the HVIL constantly monitors the traction voltage system, any fault in the system would deactivate the system, thus protecting a user measuring the traction voltage in the system using the measuring device of the present disclosure.

According to one example embodiment, the measuring device is adapted to be attached to a cable comprising the traction voltage conductors.

According to one example embodiment the measuring device is adapted to be attached to a cable comprising both the traction voltage conductors and low voltage conductors of the HVIL.

According to one example embodiment the measuring device is arranged to be connected to a first connector connecting to a first cable and the traction voltage system in one end and to a second connector connecting to a second cable and the high voltage appliance in another end.

According to one example embodiment the measuring device is arranged to be connected to a first connector connecting to a first cable and the traction voltage system in one end and to a second connector connecting to a second cable and the high voltage appliance in another end.

According to one example embodiment the measuring device is arranged to be connect in series between the traction voltage and the high voltage appliance.

According to one example embodiment the first and second resistor have a resistance in the range of 200-400 kΩ.

According to one example embodiment the connectors of the measuring device are bayonet mounts.

Bayonet mounts mitigates the risk of unintended detachment of the measuring device, while still allowing for easy attachment and detachment by a technician.

According to one example embodiment the connector is a quick connector.

According to a second aspect, the present disclosure relates to a method for measuring of traction voltage being supplied by a traction voltage system to a high voltage appliance in a vehicle with the motor in operation, the method comprising the steps of:
- Turning off the traction voltage system
- Connecting a measuring device in accordance with the first aspect of the disclosure to a first and second traction voltage conductor of the traction voltage system
- Connecting the measuring device to a Hazardous Voltage Interlock Loop, HVIL, of the vehicle
- Turning on the traction voltage system, and
- Connecting a first and second probe of a voltage measuring instrument to the terminals of the measuring device to measure the voltage in the traction voltage system.

By using the enclosed measuring device, the voltage measuring instrument can be connected to the traction voltage system while it is operating, without the risk of exposing the user of the device to the high voltage of the traction voltage system.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

Aspects and embodiments are now described, by way of example, with reference to the accompanying drawings, in which:
Figure 1 schematically illustrates parts of a traction voltage system of a vehicle
Figure 2 schematically illustrates parts of a traction voltage system of a vehicle with a measuring device attached
Figure 3 shows a flowchart illustrating a method for measuring of traction voltage in a vehicle.

### DETAILED DESCRIPTION

The aspects of the present disclosure will now be described more fully hereinafter with reference to the accompanying drawings, in which certain embodiments of the invention are shown.

These aspects may, however, be embodied in many different forms and should not be construed as limiting; rather, these embodiments are provided by way of example so that this disclosure will be thorough and complete, and to fully convey the scope of all aspects of invention to those skilled in the art. Like numbers refer to like elements throughout the description.

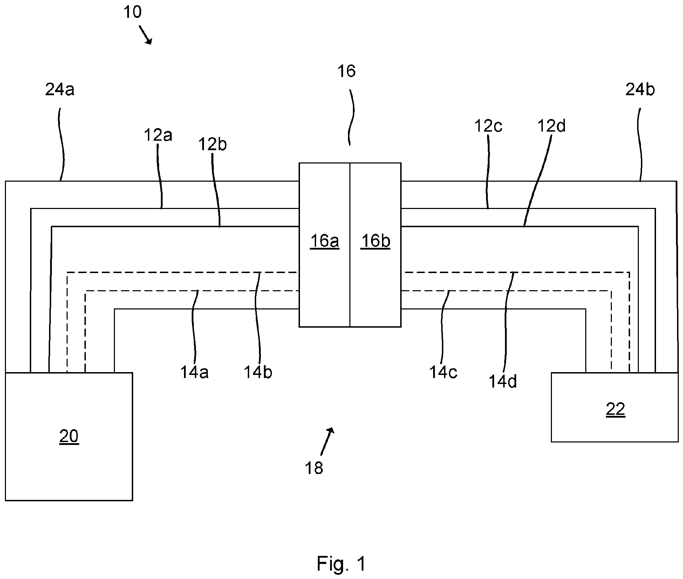

Figure **1** shows a part of a traction voltage system **10** of a vehicle. The traction voltage system **10** is a high voltage system. The traction voltage system **10** is powered by a high voltage power source (not shown). The high voltage power source could for example comprise one or more batteries, one or more fuel cells or one or more generators.

The traction voltage system **10** comprises a traction junction box **20** for distribution of traction voltage to a number of high voltage appliances **22.** The high voltage appliances could for example be converters or compressors. The traction junction box **20** is in turn connected to the high voltage power source.

The system further comprises traction voltage conductors **12a-12d.** The first conductor, comprising conductors **12a** and **12c**, could for example have positive polarity. The second conductor, comprising conductors 12b and 12d, could for example have negative polarity. The traction voltage conductors could for example be comprised in a high voltage cable **24a**, **24b.** The traction voltage conductors **12a-d** are used to conduct voltage from the junction box **20** to the consumers **22.**

A connecting device **16** is disposed between the junction box **20** and the consumer **22.** The connecting device **16** is in figure **1** depicted as a connector **16** of the traction voltage system. The connector **16** of the traction voltage system **10** comprises a first part **16a** and a second part **16b** which can be disconnected to allow for connection of additional components to the traction voltage system **10.**

In alternative embodiments, the junction box **20** and the consumer **22** could each comprise a connector. In this case, a cable having a connector at each end is used to connect the junction box **20** and the consumer **22.** For example, the junction box **20** and the consumer **22** could comprise a male connector, while the cable could comprise a female connector at each end.

The traction voltage system **10** in figure 1 further comprises a High Voltage Interlock Loop (HVIL) **18.** The HVIL **18** is in the example embodiment of figure 1 comprises HVIL conductors **14a-d** integrated in the same cables **24a, 24b** as the traction voltage conductors **12a-d** but could also be disposed as separate parts. The HVIL **18** comprises a low voltage loop which monitors the parts of the traction voltage system.

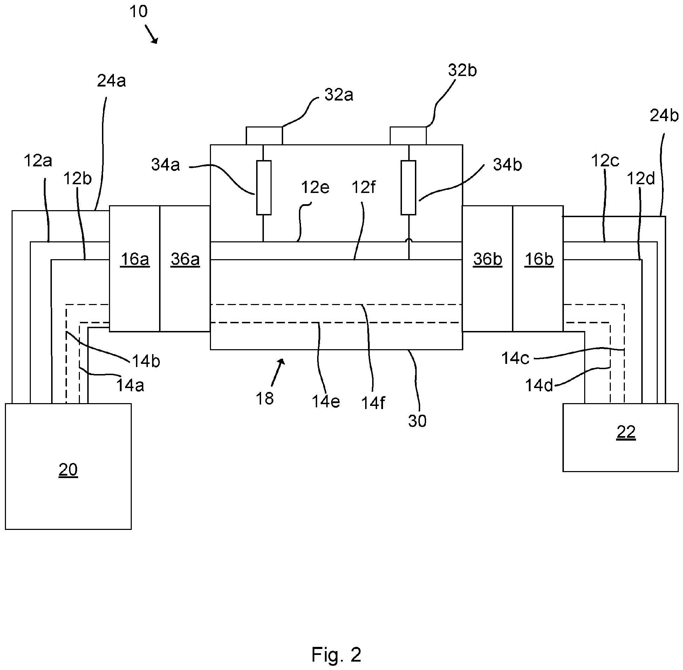

Figure 2 shows the same part of the traction voltage system **10** as figure 1, but with a measuring device **30** in accordance with an embodiment of the present disclosure installed. The measuring device **30** is illustrated as a high voltage breakout box.

The measuring device **30** comprises a pair of terminals **32a**, **32b.** The terminals **32a**, **32b** allow for connection of a couple of probes of a voltage measuring instrument to the measuring device **30.** The measuring instrument could be a voltmeter or a multimeter.

The measuring device **30** further comprises a pair of resistors **34a**, **34b.** The resistors **34a**, **34b** are disposed between the traction voltage conductors **12a-d** and the terminals **32a, 32b.** The resistors could have a resistance of 200-400 kΩ, for example 300 kΩ.

The measuring device **30** shown in figure 2 further comprises connectors **36a, 36b** for connection of the measuring device to the traction voltage conductors **12a-d.** The connectors **36a**, **36b** of the measuring device are configured to be connected to the traction voltage system **10** via the connectors **16a**, **16b** of the traction voltage system.

The measuring device **30** shown in figure 2 further comprises traction voltage conductors **12e**, **12f.** The measuring device is in figure 2 connected to the traction voltage system **10** by connecting the traction voltage conductors **12a-12d** of the vehicle to the traction voltage conductors **12e-12f** of the measuring device.

The connectors **36a**, **36b** of the measuring device could for example comprise bayonet mounts. The bayonet mounts could be connected to corresponding connectors **16a**, **16b** the cable **24a**, **24b** enclosing the traction voltage conductors **12a-d.** The connectors **36a**, **36b** of the measuring device could alternatively be quick connectors.

In the alternative embodiment where the junction box **20** and the consumer **22** each comprises a quick connector connected by a cable, the measuring device **30** could be attached by removing the cable at one end and providing an additional cable for connecting the other side of the measuring device **30.** Alternatively, the existing cable could be removed entirely before attaching the measuring device using a pair of separate cables compatible with the measuring device **30.**

The connectors **36a**, **36b** of the measuring device **30** shown in figure 2 further connects to the HVIL of the vehicle. This is in figure 2 performed by connecting the HVIL conductors **14a-14d** of the vehicle to HVIL conductors **14e**, **14f** of the measuring device. Thus, the series coupling of the measuring device **30** between the connectors **16a**, **16b** closes the HVIL.

Advantageously, the provision of the resistors **34a**, **34b** between the conductors **12e**, **12f** of the traction voltage system and the measuring probes **32a**, **32b**, the user is protected from being exposed to harmful current of the traction voltage system. This allows for measurement to be conducted while the vehicle is operating, without the risk of harming the technician.

Further advantageous, any detachment of the measuring device 30 from the connectors 16a, 16b would break the HVIL which would activate a mechanism (not shown) for closing down the traction voltage system.

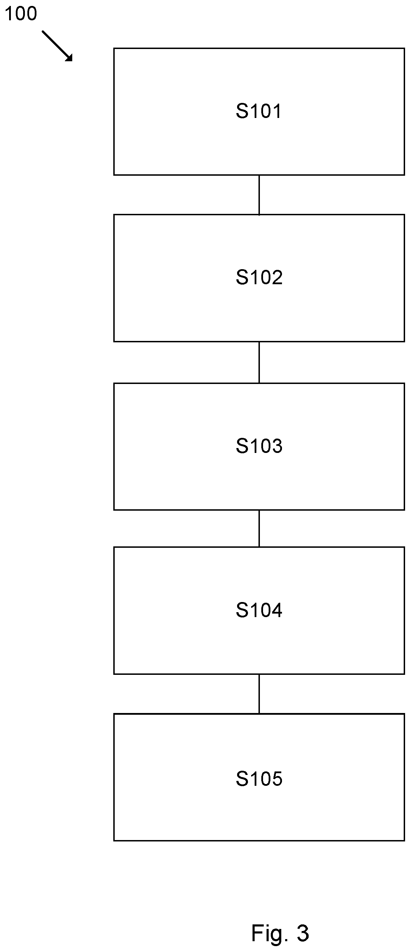

Figure 3 shows a flowchart illustrating a method for measuring of traction voltage in a vehicle. In a first step **S101,** the traction voltage of the vehicle is turned off. This could for example be done using a switch or any other feature provided in the vehicle for turning off the high voltage system.

In a further step **S102**, the measuring device is connected to the traction voltage system

In a further step **S103**, the measuring device is connected to the HVIL

In a further step **S104**, the high voltage system is turned on

In embodiments where the conductors of the traction voltage system and the conductors of the HVIL are comprised within the same cable, steps **S102** and **S103** are conducted simultaneously.

In a further step **S105**, a voltage measuring instrument is connected to the measuring device to measure the traction voltage

The method thus allows for measuring of traction voltage while the system is turned on.

The aspects of the present disclosure have mainly been described above with reference to a few embodiments and examples thereof. However, as is readily appreciated by a person skilled in the art, other embodiments than the ones disclosed above are equally possible within the scope of the invention, as defined by the appended patent claims.

Thus, while various aspects and embodiments have been disclosed herein, other aspects and embodiments will be apparent to those skilled in the art. The various aspects and embodiments disclosed herein are for purposes of illustration and are not intended to be limiting, with the true scope and spirit being indicated by the following claims.

## Claims

1. A measuring device (30) for enabling measuring of traction voltage being supplied by a traction voltage system (10) to a high voltage appliance (22) in a vehicle with the traction voltage system in operation,
the measuring device (30) being configured to be detachably connected between the vehicle traction voltage system (10) and the high voltage appliance (22), the measuring device (30) comprising:
a first and second terminal (32a, 32b) configured to receive a first and second probe of a voltage measuring instrument, and
a first and second resistor (34a, 34b) arranged to connect each terminal (32a, 32b), upon the measuring device (30) being attached to the vehicle voltage traction system (10), to a first and second traction voltage conductor (12a-f) of the traction voltage system (10) extending through the measuring device (30),
wherein the measuring device (30) is configured to, upon the measuring device (30) being attached to the vehicle voltage traction system (10), connect to a Hazardous Voltage Interlock Loop, HVIL (18), of the vehicle extending through the measuring device (30) so that the HVIL (18) is broken when the measuring device (30) is detached from the traction voltage system (10), thereby inactivating the traction voltage system (10).

2. The measuring device (30) according to claim 1 wherein the measuring device (30) is adapted to be attached to a cable (24a, 24b) comprising the traction voltage conductors (12a-d).

3. The measuring device according to any of the preceding claims wherein the measuring device (30) is adapted to be attached to a cable (24a, 24b) comprising both the traction voltage conductors (12a-d) and low voltage conductors (14a-c) of the HVIL (18).

4. The measuring device (30) according to claim 4, the measuring device (30) being arranged to be connected to a first connector (16a) connecting to a first cable (24a) and the traction voltage system (10) in one end and to a second connector (16b) connecting to a second cable (24b) and the high voltage appliance (22) in another end.

5. The measuring device according to claim 4, the measuring device being arranged to be connect in series between the traction voltage (10) and the high voltage appliance (22).

6. The measuring device according to any of the preceding claims, the first and second resistor having a resistance value in the range of 200-400 kΩ.

7. The measuring device according to any one of claims 4-6 wherein the connectors (36a, 36b) of the measuring device (30) are bayonet mounts

8. A method (100) for measuring of traction voltage being supplied by a traction voltage system (10) to a high voltage appliance (22) in a vehicle, the method comprising the steps of:
- Turning off (S101) the traction voltage system (10)
- Connecting (S102) a measuring device (30) in accordance with any of the claims 1-7 to a first and second traction voltage conductor (12a-d) of the traction voltage system (10)
- Connecting (S103) the measuring device (30) to a Hazardous Voltage Interlock Loop, HVIL (18), of the vehicle
- Turning on (S104) the traction voltage system (10), and
- Connecting (S105) a first and second probe of a voltage measuring instrument to the terminals (32a, 32b) of the measuring device (30) to measure the voltage in the traction voltage system (10)
